# EUROPÄISCHE PATENTANMELDUNG

(11) **EP 1 713 134 A1**
(43) Veröffentlichungstag der Anmeldung: **18.10.2006**
(21) Anmeldenummer: 05252335.4
(22) Anmeldetag: 14.04.2005
(51) Int. Cl.: H01L 41/113, H01L 41/24

(54) **Vibrationssensor und Verfahren zu dessen Herstellung**

(71) Anmelder: Delphi Technologies, Inc., Troy, MI 48007 (US)
(72) Erfinder: Steins, Harald, 54290 Trier (DE)
(74) Vertreter: Jones, Keith William

(57) **Zusammenfassung**

Es wird ein Vibrationssensor, insbesondere ein Piezosensor mit einem sich vorzugsweise in einer Ebene erstreckenden drucksensitiven Element, insbesondere einem Piezoelement angegeben, bei dem das drucksensitive Element durch eine Mehrzahl von Einzelelementen (40) gebildet wird, weil auf diese Weise das drucksensitive Element, das z.B. einen Sinterungsvorgang durchläuft, während des Sinterungsprozesses in einer höheren Packungsdichte anordenbar ist, als dies bei bisher bekannten Konfigurationen des drucksensitiven Elementes möglich war.

## Beschreibung

Die Erfindung betrifft einen Vibrationssensor, insbesondere einen auf dem Piezo-Effekt basierenden Vibrationssensor mit einem Piezoelement, sowie ein Verfahren zu dessen Herstellung. Ferner betrifft die Erfindung die Verwendung des erfindungsgemäßen Vibrationssensors als Klopfsensor oder Verbrennungserkennungssensor durch Verbrennungsgeräuschmessung (Verbrennungsvibrationsmessung) für einen Verbrennungsmotor, wie er z.B. in Kraftfahrzeugen Verwendung findet.

Piezosensoren, auch in ihrer Verwendung als Vibrationssensoren, sind allgemein bekannt. Bei solchen bekannten Sensoren ist das Piezoelement als Scheibe mit einer Mittelbohrung ausgeführt. Zusammen mit weiteren Elementen, insbesondere einem bei zusammengebautem Vibrationssensor jeweils unmittelbar auf der Oberseite und der Unterseite des Piezoelementes angeordneten Kontaktring wird das Piezoelement durch einen Sensorträger gehalten und durch Anziehen einer Mutter in geeigneter Weise vorgespannt.

Nachteilig bei solchen bekannten Sensoren sind die hohen Kosten, die mit der Herstellung solcher scheibenförmiger Piezoelemente einhergehen. Diese hohen Kosten ergeben sich vor allem daraus, dass die Herstellung solcher Piezoelemente in einem Sinterungsprozess in einer mit Aluminium-Oxid beschichteten Vorrichtung erfolgt, die nur für eine begrenzte Anzahl von Sinterungsprozessen verwendbar ist. Zudem ist die Packungsdichte, also die Anzahl der Piezoelemente in der Vorrichtung, durch die Scheibenform der einzelnen Elemente begrenzt.

Der Erfindung liegt daher die Aufgabe zugrunde, einen Vibrationssensor anzugeben, der die oben genannten Nachteile bei der Herstellung vermeidet.

Diese Aufgabe wird erfindungsgemäß mit den Merkmalen des Anspruchs 1 gelöst. Dazu ist bei einem Vibrationssensor, insbesondere einem Piezo-Sensor, mit einem sich vorzugsweise in einer Ebene erstreckenden drucksensitiven Element, insbesondere Piezoelement, das drucksensitive Element durch eine Mehrzahl von Einzelelementen gebildet.

Die Aufteilung des bisher stets einstückigen Piezoelements in eine Mehrzahl von Einzelelementen hat den Vorteil, dass die jeweiligen Einzelelemente bei der Herstellung, insbesondere während des Sinterungsprozesses, günstiger angeordnet werden können, so dass in einem Sinterungsvorgang eine große Anzahl von Einzelelementen hergestellt werden kann, die sich zu einer größeren Anzahl von drucksensitiven Elementen kombinieren lassen als dies bei einstückigen Piezoelementen möglich wäre. Bei bisher üblichen Piezoelementen in Scheibenform, also mit einer Mittelöffnung, ist die Packungsdichte einerseits durch die Außenkontur des Elementes sowie die nicht nutzbare Fläche der Mittelöffnung begrenzt. Wenn die bekannte Scheibenform des Piezoelementes entsprechend der Erfindung quasi "aufgeteilt" wird ergibt sich eine Mehrzahl von Einzelelementen, die beim Sintern selbstverständlich nicht in der Position und Orientierung angeordnet werden müssen, in der sie später zur Verwendung im Vibrationssensor vorgesehen sind, so dass die Einzelelementen, die z.B. eine rechtwinklige Außenkontur haben, beim Sintern in einer Art und Weise angeordnet werden können, die eine optimale Ausnutzung der zur Verfügung stehenden Fläche gestattet.

Die Erfindung geht dabei von der Erkenntnis aus, dass der piezo-elektrische Effekt auf einer durch Druck bewirkten Ladungsverschiebung beruht. Über einem gewissen Volumen piezoelektrischen Materials kann also bei einem bestimmten Druck eine definierte elektrische Spannung gemessen werden. Wird das Volumen verkleinert, z.B. beim Übergang von einem scheibenförmigen Piezoelement zu einem einzelnen Piezoelement in Form eines Scheibensegmentes, so verringert sich die bei gleichem Druck messbare Spannung proportional zum Verhältnis vom Volumen der Scheibe zum Volumen des Scheibensegments. Eine zu geringe Spannung ist unerwünscht, weil damit die Anforderungen an die elektrische Verstärkung des Signals steigen. Um dies zu umgehen, sieht die Erfindung weiter vor, statt eines einzelnen günstiger im Sinterungsprozeß handhabbaren Piezoelements bei jedem Vibrationssensor eine Mehrzahl solcher Einzelelementen, vorzugsweise eine Mehrzahl gleichförmiger Einzelelemente, zu verwenden. Wenn alle Einzelelemente elektrisch parallel kontaktiert sind, ergibt sich eine Addition der über jedem Einzelelement abgreifbaren Spannung. Je dichter die Einzelelemente im Vibrationssensor im Verhältnis zueinander angeordnet werden können, desto mehr nähert sich das Gesamtvolumen der Einzelelemente dem Volumen des ursprünglichen Scheibenelementes, so dass keine zusätzlichen Maßnahmen zur elektrischen Verstärkung des Messwertes erforderlich sind, die über solche Maßnahmen hinausgehen, die zur Aufbereitung des Messwertes auch bei den bisher bekannten Vibrationssensoren erforderlich waren.

Insgesamt ergibt sich damit ein in seinem Herstellungsverfahren optimierter Vibrationssensor, der sich aufgrund der verbesserten Herstellungsweise auch preislich günstiger fertigen lässt.

Vorteilhafte Ausgestaltungen der Erfindung sind Gegenstand der Unteransprüche.

Wenn die Einzelelemente ringförmig oder zumindest im Wesentlichen ringförmig, also z.B. auch elliptisch, oval oder ggf. sogar in Form einer "8", angeordnet sind, ergibt sich die Möglichkeit auf die bekannte und gebräuchliche Form eines Vibrationssensors zurückzugreifen, bei der ein Sensorträger, ein sog. "sleeve", eine Grundfläche und einen sich darauf erhebenden Zylinder, der an seinem freien Ende ein Gewinde aufweist, umfasst, wobei die einzelnen Elemente des Vibrationssensors und darunter auch das drucksensitive Element schichtweise übereinander angeordnet sind und der Zylinder durch jeweils eine Mittelbohrung jedes Elements hindurchragt. Selbstverständlich können die einzelnen Sensorelemente auch geklebt oder in sonst geeigneter Weise kombiniert werden, so dass der Sensorträger ganz oder teilweise entfällt.

Wenn die Einzelelemente auf einem Träger, insbesondere einem ersten Kontaktring, angeordnet sind, erleichtert dies die Handhabung der Gesamtheit der für jeweils einen Vibrationssensor vorgesehenen piezoelektrischen Einzelelemente.

Bevorzugt ist ein solcher Träger aus einem vorzugsweise weichelastischen Material gebildet, in das das oder jedes Einzelelement eingebettet ist oder sich einbetten lässt und zwar zumindest mit seiner Unterseite, so dass Ober- und Unterseite des Elementes oder der Einzelelemente frei liegen.

Alternativ kommt einer ersten Kontaktscheibe eine Doppelfunktion nämlich sowohl zur Kontaktierung des oder jedes piezo-elektrischen Einzelelementes als auch zu dessen/deren Halterung/Führung zu. Dazu weist die erste Kontaktscheibe vorteilhaft zum Aufnehmen jeweils eines Einzelelementes eine Aufnahme, z.B. in Form von Vertiefungen oder dergleichen, auf.

Wenn das oder jedes piezo-elektrische Einzelelement rechteckig oder quadratisch ist, ergeben sich optimale Verhältnisse zur Ausnutzung des zur Verfügung stehenden Raums beim Sinterungsprozess, weil rechteckige oder quadratische Einzelelemente eine maximale Packungsdichte ermöglichen.

Wenn das oder jedes Einzelelement trapezförmig ist, ist immer noch eine nahezu optimale Ausnutzung des zur Verfügung stehenden Raums/der zur Verfügung stehenden (Grund-)Fläche beim Sinterungsprozess möglich. Zudem ist bei einer Anordnung der piezoelektrischen Einzelelemente, in einer Form, die eine Scheibe nachbildet, mit dem Summenvolumen der trapezförmigen Einzelelemente eine bessere Annäherung an das Volumen des ursprünglich scheibenförmigen, einstückigen Piezoelementes möglich.

Wenn das oder jedes Einzelelement die Form eines Scheibensegments hat, ist mit dem Summenvolumen der Einzelelemente die beste Annäherung an das Volumen des ursprünglich scheibenförmigen, einstückigen Piezoelementes möglich. Allerdings ist die Packungsdichte beim Sinterungsprozess nicht so günstig wie bei rechteckigen oder trapezförmigen Einzelelementen. Insgesamt ist die Packungsdichte von Scheibensegmenten aber immer noch sehr viel günstiger als die Packungsdichte von einstückigen Scheiben.

Sofern erforderlich kann eine Vereinheitlichung der Polarisationsrichtung einer Gruppe von Einzelelementen in einem Sensor durch Prozesssteuerung, also beim Bestücken der Einzelelemente, durch optische Polarisationsrichtungsindikation oder durch mechanische Kodierung erreicht werden. Die Verwendung der nicht symmetrischen Trapezform ist ein Beispiel für eine mechanische Kodierung der Piezoorientierung, wenn eine einheitliche Polarisationsrichtung aller Einzelelemente einer Gruppe gewünscht wird.

Die Erfindung bezieht sich neben dem Vibrationssensor selbst auch auf ein Verfahren zu dessen Herstellung, wobei in einem Sinterungsprozess eine Vielzahl piezoelektrischer Einzelelemente in eine Sinterungsvorrichtung eingebracht wird, derart, dass die wirksame Grundfläche der Sinterungsvorrichtung vollständig oder zumindest nahezu vollständig mit Einzelelementen bedeckt ist, wobei im Anschluss an den Sinterungsvorgang die Einzelelemente aus der Sinterungsform entnommen werden und für jeden Vibrationssensor die benötigte Anzahl von Einzelelementen ausgewählt wird und wobei die ausgewählten Einzelelemente auf einem Träger, insbesondere einem ersten Kontaktring, angeordnet werden und zusammen mit dem Träger sowie vorzugsweise einem weiteren Kontaktring zu einem Vibrationssensor zusammengebaut werden.

Schließlich bezieht sich die Erfindung auch auf eine bevorzugte Verwendung des erfindungsgemäßen Vibrationssensors als Sensor zur Verbrennungsgeräuschmessung (Verbrennungsvibrationsmessung) in einem Kraftfahrzeug, wobei das sog. "Klopfen" ein Beispiel für Verbrennungsgeräusche darstellt.

Der Vorteil der Erfindung und ihrer Ausgestaltungen besteht auch darin, dass sich das Gesamtvolumen des piezoelektrischen Materials sehr viel leichter an unterschiedliche Anwendungsfälle anpassen lässt als dies bei einem einstückigen drucksensitiven, piezoelektrischen Element der Fall wäre.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

### Darin zeigen

- Fig. 1: eine Explosionsdarstellung eines bekannten Vibrationssensors mit einem einstückigen Piezoelement als drucksensitivem Element und
- Fig. 2: in einer Darstellung in Draufsicht zunächst ein einstückiges Piezoelement in Form einer gelochten Scheibe als drucksensitives Element sowie exemplarisch drei weitere Konfigurationen eines jeweils eine Mehrzahl von piezo-elektrischen Einzelelementen umfassenden drucksensitiven Elements, wobei mit den Einzelelementen jeweils die Scheibenkontur des einstückigen drucksensitiven Elements nachgebildet wird.

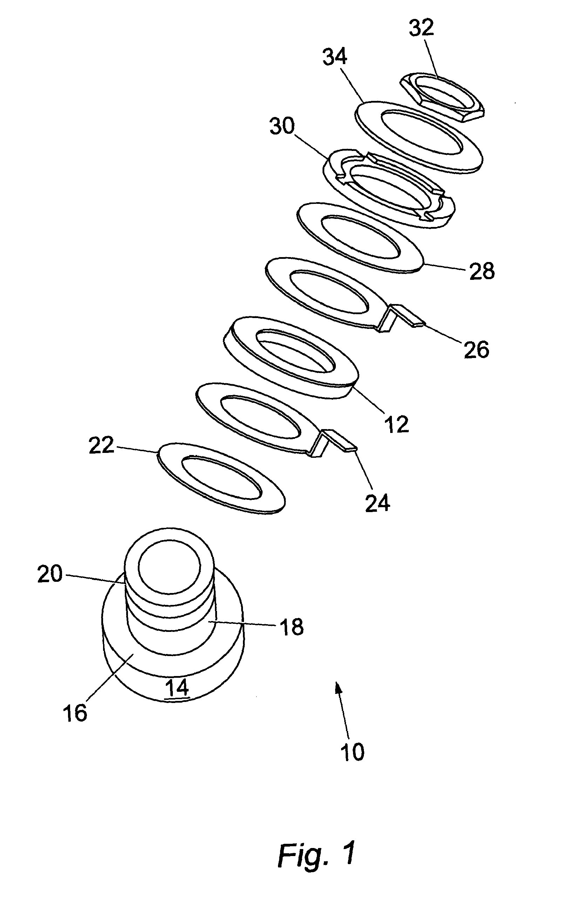

Fig. 1 zeigt eine Explosionsdarstellung eines bekannten Vibrationssensors 10 mit einem drucksensitiven Element in Form eines einstückigen Piezoelements 12. Der Vibrationssensor 10 umfasst einen Sensorträger 14, der auch als "sleeve" bezeichnet wird. Der Sensorträger 14 umfasst eine Grundfläche 16 und einen sich darauf erhebenden Zylinder 18, der an seinem freien Ende ein Gewinde 20 aufweist. Die einzelnen Elemente des Vibrationssensors 10, wie nachfolgend beschrieben, werden bei Verwendung eines solchen Sensorträgers 14 auf der Grundfläche 16 schichtartig übereinander angeordnet, wobei der Zylinder 18 durch jeweils eine Mittelbohrung jedes Elements hindurchragt. In der Reinfolge der Anordnung der Einzelelemente am Sensorträger 14 ist ein erstes Element ein Isolationsring 22 gefolgt von einem ersten oder unteren Kontaktring 24. Der erste oder untere Kontaktring 24 dient als erster Kontakt bei der Kontaktierung des Piezoelementes 12. Entsprechend ist oberhalb des Piezoelementes 12 ein weiterer oder oberer Kontaktring 26 vorgesehen, auf den nach einem weiteren Isolationsring 28 eine sogenannte seismische Masse 30 ("load washer") folgt. Vor einer Abschlussmutter 32, die zum Eingriff mit dem Gewinde 20 des Zylinders 18 am Sensorträgers 14 vorgesehen ist, kann optional noch ein Federring 34 vorgesehen sein. Die beiden Kontatkringe 24, 26 weisen in an sich bekannter Weise Kontaktstifte auf, mit denen ein Abgriff der elektrischen Spannung über dem drucksensitiven Element, vorliegend also dem Piezoelement 12, und damit letztlich der Erhalt eines Druck- oder Vibrationsmesswertes möglich ist.

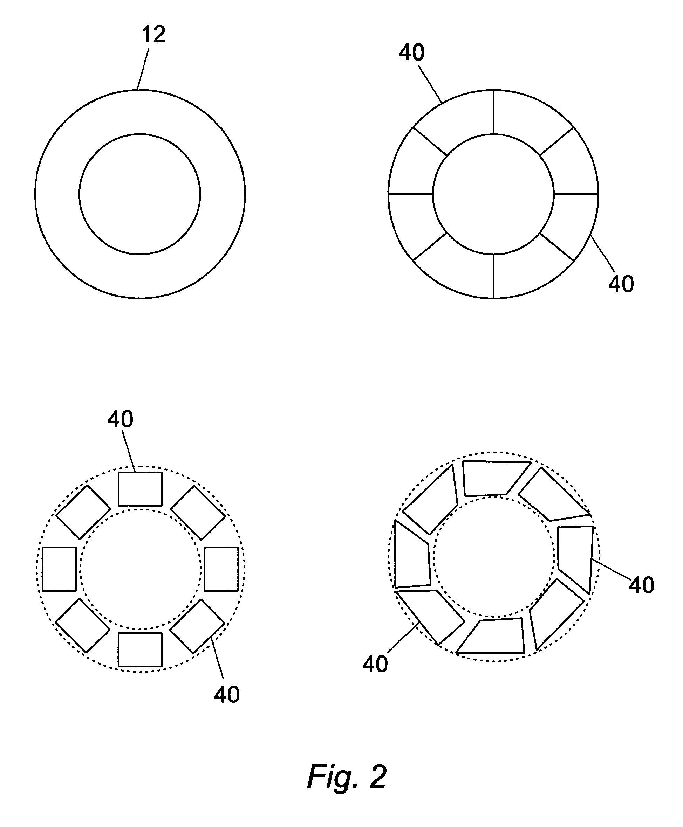

Fig. 2 zeigt in einer Darstellung in Draufsicht verschiedener Konfigurationen eines drucksensitiven Elements. Die Darstellung links oben in Fig. 2 zeigt als drucksensitives Element das einstückige Piezoelement 12 aus der Darstellung in Fig. 1. Das einstückige Piezoelement 12 hat die Form einer Scheibe mit einer Mittelbohrung. Die anderen Darstellungen zeigen jeweils Konfigurationen, bei denen das drucksensitive Element eine Mehrzahl von Einzelelementen, bei einem Piezosensor also piezoelektrischen Einzelelementen 40, umfasst.

Die Darstellung oben rechts zeigt ein drucksensitives Element mit Einzelelementen 40 in Form von Scheibensegmenten. Die Darstellung unten links zeigt ein drucksensitives Element mit rechteckigen Einzelelementen 40 und die Darstellung unten rechts zeigt schließlich ein drucksensitives Element mit trapezförmigen Einzelelementen 40, wobei die unsymmetrische Trapezform ein Beispiel für eine mechanische Kodierung der Polarisationsrichtung darstellt.

Man erkennt, dass sich die Einzelelemente 40 zueinander so orientieren lassen, dass die Form des ursprünglich einstückigen Piezoelements 12, also die Scheibenform, nachgebildet wird. Bei Einzelelementen 40 in Form von Scheibensegmenten lässt sich die ursprüngliche Form optimal nachbilden. Die Möglichkeit der Anordnung solcher Einzelelemente 40 beim Sinterungsprozess in einer Ebene ist jedoch nicht so optimal wie dies für rechtwinklige oder trapezförmige Einzelelemente 40 gilt. Allerdings ist bei rechteckigen Einzelelementen 40 die Nachbildung der Scheibenkontur nicht so günstig wie bei trapezförmigen Einzelelementen 40. Zu berücksichtigen ist dabei, dass es im Hinblick auf die Nachbildung der Scheibenkontur nicht so sehr auf die tatsächliche Nachbildung der scheibenförmigen Grundfläche ankommt und hier vielmehr der bestimmende Parameter das Volumen des piezoelektrischen Materials ist. Hier ist das Gesamtvolumen der Einzelelemente 40 in Form von Scheibensegmenten nahezu identisch mit dem Gesamtvolumen des einstückigen Piezoelements 12 und das Gesamtvolumen der trapezförmigen Einzelelemente 40 nur geringfügig geringer als das Gesamtvolumen des einstückigen Piezoelements 12. Auch wenn das Gesamtvolumen der rechteckigen Einzelelemente 40 im Vergleich zu den anderen beschriebenen Konfigurationen ungünstiger ist, ergibt sich immer noch ein funktionstüchtiger Sensor. Zudem kann das Gesamtvolumen des piezoelektrischen Materials jederzeit dadurch erhöht werden, dass bei gleichbleibender Grundkontur der Einzelelemente 40 deren "Höhe" geeignet erhöht wird. Die Einzelelemente 40 mit rechteckiger Grundkontur sind im Hinblick auf die Ausnutzung des zur Verfügung stehenden Raumes beim Sinterungsprozess genauso günstig wie die Einzelelemente 40 mit trapezförmiger Grundkontur. Allerdings ist bei den Einzelelementen 40 mit trapezförmiger Grundkontur beim Bestücken des Vibrationssensors 10 auf die jeweilige Orientierung zu achten, so dass sich die Komplexität des Montageprozesses geringfügig erhöht. Der Montageprozess ist bei Einzelelementen mit rechteckiger oder sogar quadratischer Grundkontur am einfachsten, weil die Orientierung der Einzelelemente kaum oder gar nicht geändert werden muss.

Um die "Ausbeute" eines Sinterungsprozess noch weiter zu erhöhen, ist es möglich, bei einem Vibrationssensor 10, bei dem das drucksensitive Element durch eine Mehrzahl von Einzelelementen 40 gebildet ist, eine verringerte Anzahl von Einzelelementen, also z.B. im Falle der rechteckigen Einzelelemente 40 in der unteren linken Darstellung in Fig. 2 anstelle von acht Einzelelementen 40 nur vier Einzelelemente 40 vorzusehen. Bei einer verringerten Anzahl der Einzelelemente verringert sich das Volumen des piezoelektrischen Materials und damit insgesamt die bei ansonsten gleichem Druck an den Kontaktringen 24, 26 abgreifbare Spannung. Dies lässt sich aber durch eine Verstärkung des Messwertes ohne weiteres kompensieren, so dass auch eine Ausführung des Vibrationssensors bei dem nicht die maximal mögliche Anzahl von Einzelelementen 40 verwendet wird, funktionstüchtig und insbesondere im Hinblick auf wirtschaftliche Erwägungen sinnvoll ist.

Damit lässt sich die Erfindung kurz wie folgt darstellen:
Es wird ein Vibrationssensor, insbesondere ein Piezosensor mit einem sich vorzugsweise in einer Ebene erstreckenden drucksensitiven Element, insbesondere einem Piezoelement 12 angegeben, bei dem das drucksensitive Element durch eine Mehrzahl von Einzelelementen 40 gebildet wird, weil auf diese Weise das drucksensitive Element, das z.B. einen Sinterungsvorgang durchläuft, während des Sinterungsprozesses in einer höheren Packungsdichte anordenbar ist, als dies bei bisher bekannten Konfigurationen des drucksensitiven Elementes möglich war.

### Bezugszeichenliste

- 10: Vibrationssensor
- 12: Piezoelement
- 14: Sensorträger
- 16: Grundfläche
- 18: Zylinder
- 20: Gewinde
- 22: Isolationsring
- 24: erster/unterer Kontaktring
- 26: zweiter/oberer Kontaktring
- 28: weiterer Isolationsring
- 30: seismische Masse
- 32: Abschlussmutter
- 34: Federring

- 40: Einzelelement

## Patentansprüche

1. Vibrationssensor (10), insbesondere Piezo-Sensor, mit einem sich vorzugsweise in einer Ebene erstreckenden drucksensitiven Element, insbesondere Piezoelement (12),
**dadurch gekennzeichnet, dass**
das drucksensitive Element (12) durch eine Mehrzahl von Einzelelementen (40) gebildet wird.

2. Vibrationssensor nach Anspruch 1, wobei die Einzelelemente (40) ringförmig oder zumindest im Wesentlichen ringförmig angeordnet sind.

3. Vibrationssensor nach Anspruch 2, wobei die Einzelelemente (40) auf einem Träger, insbesondere einem ersten Kontaktring (24), angeordnet sind.

4. Vibrationssensor nach Anspruch 3, wobei der Träger aus einem vorzugsweise weichelastischen Material gebildet ist, in das das oder jedes Einzelelement (40) eingebettet ist.

5. Vibrationssensor nach Anspruch 3, wobei der erste Kontaktring (24) als Träger zum Aufnehmen jeweils eines Einzelelementes (40) eine Anzahl von Aufnahmen aufweist.

6. Vibrationssensor nach einem der vorangehenden Ansprüche, wobei das oder jedes Einzelelement (40) rechteckig oder quadratisch ist.

7. Vibrationssensor nach einem der vorangehenden Ansprüche, wobei das oder jedes Einzelelement (40) trapezförmig ist.

8. Vibrationssensor nach einem der vorangehenden Ansprüche, wobei das oder jedes Einzelelement (40) die Form eines Scheibensegments hat.

9. Verfahren zur Herstellung eines Vibrationssensors nach einem der vorangehenden Ansprüche,
wobei in einem Sinterungsprozess eine Vielzahl der Einzelelemente (40) in eine Sinterungsvorrichtung eingebracht wird, derart dass die wirksame Grundfläche der Vorrichtung vollständig oder zumindest nahezu vollständig mit Einzelelementen (40) oder einer Grundform zum späteren Erhalt solcher Einzelelemente (40) bedeckt ist,
wobei im Anschluss an den Sinterungsvorgang die Einzelelemente (40) aus der Sinterungsform entnommen werden und für jeden Vibrationssensor (10) die benötigte Anzahl von Einzelelementen (40) ausgewählt wird und
wobei die ausgewählten Einzelelemente (40) auf einem Träger, insbesondere einem ersten Kontaktring (24), angeordnet werden und zusammen mit dem Träger sowie vorzugsweise einem weiteren Kontaktring (26) zu einem Vibrationssensor (10) zusammengebaut werden.

10. Verwendung eines Vibrationssensors nach einem oder mehreren der Ansprüche 1 bis 8 als Klopfsensor oder Sensor zur Verbrennungsgeräuschmessung in einem Kraftfahrzeug.
